Europäisches Patentamt

(19) European Patent Office

Office européen des brevets

(11) Publication number: **0 219 925**
**B1**

(12) **EUROPEAN PATENT SPECIFICATION**

(45) Date of publication of the patent specification:
02.08.89

(51) Int. Cl.⁴: **H 03 K 17/56,** H 03 K 17/04,
H 03 K 17/08

(21) Application number: 86304599.3

(22) Date of filling: 16.06.86

(54) **Switching device.**

(30) Priority: 17.06.85 JP 131295/85

(43) Date of publication of application:
29.04.87 Bulletin 87/18

(45) Publication of the grant of the patent:
02.08.89 Bulletin 89/31

(84) Designated Contracting States:
DE FR GB

(56) References cited:
EP-A-0 106 283
DE-A-3 338 627
GB-A-2 053 606
US-A-4 449 063
US-A-4 547 686

ELECTRONIQUE APPLICATIONS, no. 31, pages 35-44, August-September 1983, pages 35-44, Evry, France; "Darlington, Bipmos, Cascode: caractéristiques et critères d'emploi"
PATENT ABSTRACTS OF JAPAN, vol. 7, no. 111 (E-175) 1256, 14th May 1983 & JP - A - 58 33322
IEEE JOURNAL OF SOLID-STATE CIRCUITS, vol. SC-18, no. 6, pages 773-777, December 1983; C.-Y. WU: "A new internal overvoltage protection structure for the bipolar power transistor"

(73) Proprietor: FUJI ELECTRIC CO., LTD., 1-1, Tanabeshinden, Kawasaki- ku, Kawasaki- shi Kanagawa 210 (JP)

(72) Inventor: Shigekane, Hisao, B-406, Yokata 180- 10, Matsumoto- shi Nagano 390 (JP)

(74) Representative: Gordon, Martin, G.F. Redfern & Company Marlborough Lodge 14 Farncombe Road, Worthing West Sussex, BN11 2BT (GB)

LIBER, STOCKHOLM 1989

## Description

This invention relates to a switching device comprising two transistors, that is, a first bipolar transistor and a second field effect or bipolar transistor.

In the following description and in the drawings, identical reference numerals are used in relation to identical or corresponding components.

A prior art arrangement and problems associated with it will now be described with reference to Fig. 2 in which is shown one embodiment of a circuit comprising two transistors in a so-called cascode arrangement.

Referring to Fig. 2, a main bipolar transistor Q1 (hereinafter referred to as a BPT), a field effect transistor Q2 (hereinafter referred to as an FET) and a zener diode ZD1 are interconnected as shown.

The collector G1 and the emitter E1 of the BPT Q1, and the drain D and the source S of the FET Q2 are connected in series at the emitter E and the drain D to enable current supplied to a load (not shown) to be switched ON-OFF (for the sake of convenience, this current is referred to herein as the collector current). Further, the transistors Q1 and Q2 are collectively referred to as a composite transistor for the sake of the convenience. The zener diode ZD1 is connected between the base B1 of the BPT Q1 and the source S of the FET Q2 in such a way that the side of the base B1 comprises the cathode side of the diode.

An ON-OFF signal voltage $e_G$, determining the ON-OFF state of the collector current $I_c$ is applied by way of a driving circuit (not shown) between the gate G and the source S of the FET Q2, while a base current $I_{B1}$ supplied to the base B1 via a base power source EB connected between the base B1 of the BPT Q1 and the source S of the FET Q2 when the latter is turned ON.

The circuit is arranged to provide a composite switching element at high speed and high voltage endurance by the combination of high speed and low voltage endurance characteristics of the FET Q2 and low speed and high endurance bipolar characteristics of the transistor Q1 taking notice of the fact that the switching speed of an FET is generally greater than that of a bipolar transistor.

Referring first to the case of turning the composite transistor Q1 and Q2 ON, since the FET Q2 is connected to the emitter E1 of the BFT Q1 to enable the base current $I_{B1}$ to be turned ON and OFF in this circuit, and the base voltage $e_B$ applied to the base B1 of the BPT Q1 can be made relatively high, when the ON-OFF signal voltage $e_G$ is applied to the FET Q2 to turn the transistor Q2 ON, the voltage VDS between the drain D and the source S falls rapidly thereby abruptly raising the base current $I_{B1}$ to rapidly turn BPT Q1 ON and, accordingly, both transistors Q1, Q2 are switched ON. In this case, the zener diode ZD1 is in the OFF state (non-conduction).

When turning OFF the composite transistor Q1 and Q2, an ON-OFF signal voltage $e_G$ is applied to the FET Q2 to turn OFF the transistor Q2. The voltage VDS between the drain D and the source S of the FET Q2 abruptly increases to block the collector current $I_c$. At this instant, the collector current $I_c$ flowing through the base and the emitter of the BPT Q1 is transferred to the zener diode ZD1. In this way, since carriers accumulated at the base of the BPT Q1 are rapidly discharged, the transistor Q1 and, accordingly, the composite transistor Q1 and Q2, is rapidly turned OFF to interrupt the collector current $I_c$.

In this case, the zener diode ZD1 is used in the transferring path as described above, so as to maintain the voltage VDS between the drain and the source of the FET Q2 to lower than a limit voltage capable of turning off (switching inhibition voltage BVDS) upon turning OFF the FET Q2, that is, upon transfer of the collector current $I_c$ while hindering wasteful shunting, via the zener diode, of the base current $I_{B1}$ supplied from the base power supply EB to the connection to the base B1 of the BPT Q1, in the case where the composite transistor Q1 and Q2 is turned ON, so that it effectively forms the base current $I_B$.

In an actual device of this type, when the FET Q2 is turned OFF, stray inductance L1 of the wiring between the emitter E1 of the BPT Q1 and the drain D of the FET Q2 sometimes generates a transitional excessive voltage (spike voltage) in trying to maintain the previous current (indicated in broken line in Fig. 2), resulting in breakdown of the FET Q2.

In this case, the provision of means for delaying the FET Q2 to turn OFF lowers the spike voltage and breakdown of the FET Q2 can be prevented. However, on the other hand, the total switching time of the composite transistor Q1, Q2 becomes large and thereby the object of adopting this circuit for use in high frequency circuits cannot be attained.

In previously published DE-3 338 627 A1 there is disclosed a switching device comprising a first bipolar transistor having its collector-emitter main conductive path connected in series with the main conductive path of a second transistor having a control electrode for receiving an ON-OFF control signal voltage for switching ON and OFF the second transistor so as to open and close the series-connected main conductive paths for controlling the supply of a load current, connections being provided for connection to an auxiliary D.C. power source for supplying base current to the first transistor, a third transistor having its main conductive path connected across said base current supply connections. This prior arrangement has the disadvantage that it is necessary to supply an external signal to control the third transistor.

It is an object of the present invention to provide a switching device which ameliorates said problems and makes it possible to adopt said composite transistor arrangement for use in

high frequency switching circuits while effectively utilising said stray inductance L1.

According to this invention there is provided a switching device comprising a first bipolar transistor having its collector-emitter main conductive path connected in series with the main conductive path of a second transistor having a control electrode for receiving an ON-OFF control signal voltage for switching ON and OFF the second transistor so as to open and close the series-connected main conductive paths for controlling the supply of a load current, connections being provided for connection to an auxiliary D.C. power source for supplying base current to the first transistor, a third transistor having its main conductive path connected across said base current supply connections characterised in that a zener diode is connected between the control electrode of the third transistor and a point between the main conductive paths of the first and second transistors such that said zener diode supplies current to the control electrode of the third transistor to switch the latter to cause the first transistor to be switched OFF in a controlled manner, only when the voltage at said point causes the voltage across the zener diode to exceed its threshold voltage.

Embodiments of this invention will now be described, by way of example, with reference to the accompanying drawings in which:

Figs. 1(A) and 1(B) are respective circuit diagrams of different forms of switching device embodying this invention; and

Fig. 2 is a circuit diagram of a known form of switching device.

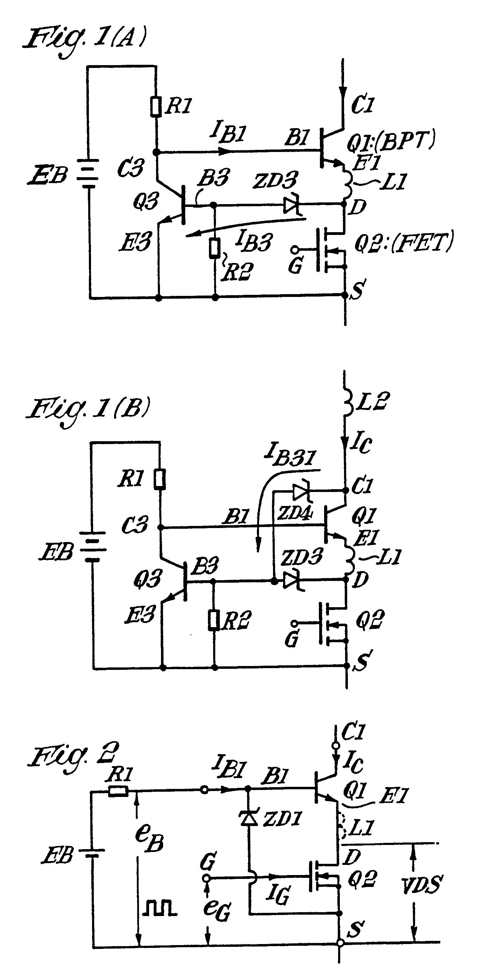

In Fig. 1(A) there is shown a modified form of the switching device shown in Fig. 2 in which, instead of the zener diode ZD1, the collector C3 and emitter E3 of an auxiliary transistor Q3 are connected so as to provide a shunt circuit for the base current $I_{B1}$ of the BPT Q1 and moreover a zener diode ZD3 is connected between a point immediately adjacent to the drain D of the FET Q2 (i.e. at a point where the stray inductance between such point and the drain D can be disregarded) and the base B3 of said auxiliary transistor Q3. In addition, the zener (threshold) voltage of the zener diode ZD3 is set lower than the maximum drain source voltage (the switching rejection voltage BVDS) of the FET Q2.

In this circuit, when the FET Q2 turns OFF, a base current $I_{B3}$ supplied to the base B3 of the auxiliary transistor Q3 through the zener diode ZD3 with a voltage induced by the stray inductance L1 so that the transistor Q3 turns ON, shunting the base current $I_{B1}$ by providing a short-circuit between the base B1 of the BPT Q1 and the source S of the FET Q2 and turning OFF transistor Q1 in a controlled manner by discharging carriers accumulated at the base of the BPT Q1. Moreover, in this case, a voltage between the drain D and source S of the FET Q2 is limited by the zener (threshold) voltage of the zener diode ZD3 and thereby prevents breakdown of the FET Q2. Thus, the composite transistor Q1, Q2 can be turned OFF quickly without resulting in breakdown of the FET Q2.

In Fig. 1(B) there is shown a modified form of the device shown in Fig. 1(A) where a voltage induced by stray inductance L2 of the external line of the collector connection for collector C1 is absorbed when the BPT Q1 turns OFF and it is used for causing transistor Q1 to turn ON. In this circuit, a zener diode ZD4 is connected between a point immediately adjacent the collector C1 of the BPT Q1 (at a point where the inductance between this point and said collector C1 can be disregarded) and the base B3 of the auxiliary transistor Q3. The zener (threshold) voltage of this zener diode ZD4 is set lower than the maximum collector-to-source voltage which can be allowed for the composite transistor Q1 and Q2.

In this circuit, when the BPT Q1 turns OFF, a base current $I_{B31}$ is additionally supplied to the base B3 of auxiliary transistor Q3 through the zener diode ZD4 with a voltage induced by the inductance L2 and thereby said transistor Q3 is triggered to become ON and the BPT Q1, and hence the composite transistor Q1, Q2 are quickly turned OFF in a controlled manner. Moreover, since the collector-emitter voltage of the BPT Q1 is kept at a value lower than the allowable value by the appropriate selection of the zener diode ZD4 breakdown of the BPT Q1 can be prevented.

In the embodiments shown in Figs. 1(A) and 1(B), the FET Q2 may be a low voltage resistance bipolar transistor and the auxiliary transistor Q3 may be an FET, and modes of operation similar to the embodiments described above can be realised.

However, where the auxiliary transistor Q3 is an FET, the base currents $I_{B3}$, $I_{B31}$ are mostly shunted via a resistor R2 provided in parallel to the path between the base B3 and emitter E3 of the auxiliary transistor Q3.

The embodiments shown in Figs. 1(A) and 1(B) each provide the advantages that:

1. When the switching device is turned OFF, a spike voltage generated by the stray inductance of the main circuit wiring between the first and second transistors reaches the base (gate) of a third transistor through the zener diode provided, and thereby the drain-to-source (collector-to-emitter) voltage of the second transistor is limited to almost the zener (threshold) voltage of said zener diode, avoiding breakdown of the second transistor.

2. The stray inductance can be effectively utilised for switching OFF the composite transistor.

3. The switching device can be adopted for use in high frequency circuits because the turn-OFF time of the second transistor and therefore the switching time of the composite transistor is not significantly delayed.

Thus the embodiments shown in Figs. 1(A) and 1(B) and described above provide a switching device comprising a first bipolar transistor Q1 having its collector-emitter main conductive path C1E1 connected in series with the main conductive path DS of a second transistor Q2 having a control electrode G for receiving an ON-OFF control signal voltage $e_G$ for switching ON and OFF the second transistor Q2 so as to open and close the series-connected main conductive paths C1E1, DS for controlling the supply of a load current $I_c$, connections being provided for supplying base current $I_{B1}$ to the first transistor Q1, a third transistor Q3 having its main conductive path C3E3 connected across said base current supply connections and a zener diode ZD3 connected between the control electrode of the third transistor Q3 and a point between the main conductive paths of the first and second transistors Q1, Q2 such that said zener diode ZD3 supplies current to the base of the third transistor Q3 to switch the latter to cause the first transistor to be switched OFF in a controlled manner, only when the voltage at said point causes the voltage across the zener diode ZD3 to exceed its threshold voltage.

## Claims

1. A switching device comprising a first bipolar transistor (Q1) having its collector-emitter (C1-E1) main conductive path connected in series with the main conductive path (D-S) of a second transistor (Q2) having a control electrode (G) for receiving an ON-OFF control signal voltage for switching ON and OFF the second transistor so as to open and close the series-connected main conductive paths for controlling the supply of a load current $I_c$, connections being provided for connection to an auxiliary D.C. power source (EB) for supplying base current ($I_{B1}$) to the first transistor, a third transistor (Q3) having its main conductive path (C3-E3) connected across said base current supply connections characterised in that a zener diode (ZD3) is connected between the control electrode (B3) of the third transistor and a point between the main conductive paths of the first and second transistors such that said zener diode supplies current to the control electrode of the third transistor to switch the latter to cause the first transistor to be switched OFF in a controlled manner, only when the voltage at said point causes the voltage across the zener diode to exceed its threshold voltage.

2. A switching device according to claim 1, wherein said second and/or third transistor is a field effect transistor whose drain-source path provides said main conductive path.

3. A switching device according to claim 1, wherein said second and/or third transistor is a bipolar transistor whose collector-emmiter path provides said main conductive path.

4. A switching device according to claim 1, wherein said second transistor is a field effect transistor and said third transistor is a bipolar transistor.

5. A switching device according to any one of the preceding claims, wherein the point between the main conductive paths of the first and second transistors to which the zener diode is connected is made immediately adjacent the second transistor to minimise stray inductance between said point and the main conductive path of said second transistor.

6. A switching device according to any one of the preceding claims, wherein a further zener diode (ZD4) is connected between the control electrode of the third transistor and the side of the main conductive path of the first transistor remote from the second transistor.

7. A switching device according to claim 6, wherein said further zener diode is connected to the side of the main conductive path of the first transistor at a position immediately adjacent the latter to minimise stray inductance between said position and the first transistor.

## Patentansprüche

1. Schalteinrichtung bestehend aus einem ersten bipolaren Transistor (Q1), dessen Kollektor-Emitter (C1-E1) - Hauptleitungsbahn mit der Hauptleitungsbahn (D-S) eines zweiten Transistors (Q2) in Serie geschaltet liegt, der eine Steuerelektrode (G) zur Aufnahme einer Ein /Aussteuersignalspannung zum EIN- und AUS-Schalten eines zweiten Transistors besitzt, um die in Serie geschalteten Hauptleitungsbahnen zur Steuerung der Versorgung mit einem Arbeits oder Ladestrom ($I_c$) zu öffnen oder zu schließen, wobei Verbindungsleitungen zum Anschließen einer Hilfsgleichstromquelle (EB) vorgesehen sind, um Basisstrom ($I_{B1}$) an den ersten Transistor zu liefern, und bestehend aus einem dritten Transistor (Q3), dessen Hauptleitungsbahn (C3-E3) über die Basisstromversorgungsleitungen geschaltet ist, dadurch gekennzechnet, daß zwischen der Steuerelektrode (B3) des dritten Transistors und einer Stelle zwischen den Hauptleitungsbanen des ersten und zweit Transistors eine Zenerdiode derart geschaltet liegt, daß die Zenerdiode Strom an die Steuerelektrode des dritten Transistors liefert, um letzteren zu schalten, so daß der erste Transistors auf gesteuerte Weise nur dann zum AUS-Schalten veranlaßt wird, wenn die Spannung an jener Stelle die Spannung über der Zenerdiode ihre Schwellenspannung überstegen läßt.

2. Schalteinrichtung nach Anspruch 1, dadurch gekennzechnet, daß der zweite und/oder dritte Transistor ein Feld(effekt)transistor ist, dessen Drain-Source-Bahn die Hauptleitungsbahn darstellt.

3. Schalteinrichtung nach Anspruch 1, dadurch gekennzechnet, daß der zweite und/oder dritte Transistor ein bipolarer Transistor ist, dessen Kollektor-Emitter-Bahn die Hauptleitungsbahn darstellt.

4. Schalteinrichtung nach Anspruch 1, dadurch gekennzechnet, daß der zweite Transistor ein Feld(effekt)transistor und der dritte Transistor ein bipolarer Transistor ist.

5. Schalteinrichtung nach einem der vorhergehenden Ansprüche 1 bis 4, dadurch gekennzechnet, daß die Stelle zwischen den Hauptleitungsbahnen des ersten und des zweiten Transistors, an die die Zenerdiode angeschlossen ist, unmittelbar nächstliegend zum zweiten Transistor liegt, um Streuflußinduktion zwischen jener Stelle und der Hauptleitungsbahn des zweiten Transistors auf ein Mindestmaß zurückzuführen.

6. Schalteinrichtung nach einem der vorhergehenden Ansprüche 1 bis 5, dadurch gekennzechnet, daß eine weitere Zenerdiode (ZD4) zwischen der Steuerelektrode und dem dritten Transistor und die Seite der Hauptleitungsbahn des ersten Transistors entfernt vom zweiten Transistor liegt.

7. Schalteinrichtung nach Anspruch 6, dadurch gekennzechnet, daß die weitere Zenerdiode seitlich von der Hauptleitungsbahn des ersten Transistors an einer unmittelbar letzterer nächstliegenden Stelle geschaltet liegt, um Streuflußinduktion zwischen jener Stelle und dem ersten Transistor auf ein Mindestmaß zurückzuführen.

**Revendications**

1. Dispositif de commutation comprenant un premier transistor bipolaire (Q1) dont le trajet conducteur principal collecteur-émetteur (C1-E1) est reliée en série avec le trajet conducteur principal (D-S) d'un second transsistor (Q2) ayant une électrode de commande (G) pour recevoir une tension formant signal de commande MARCHE-ARRET pour rendre passant et bloquer le second transistor de façon à ouvrir et fermer les trajets conducteurs principaux reliés en série pour commander l'alimentation en courant de charge ($I_c$), des connexions étant prévues pour la liaison avec une source auxiliaire (EB) de courant continu pour fournir le courant ($I_{B1}$) de base au premier transistor, un troisième transistor (Q3) ayant son trajet conducteur principal (C3-E3) relié en parallèle sur lesdites connexions pour l'alimentation en courant de base, caractérisé en ce qu'une diode Zener (ZD3) est montée entre l'électrode de commande (B3) du troisième transistor et un point entre les trajets conducteurs principaux des premier et second transistors de telle sorte que ladite diode Zener fournis se du courant a l'électrode de commande du troisième transistor pour réaliser la commutation de ce dernier afin de provoquer d'une manière comandée le blocage du premier transistor uniquement quand la tension audit point amène la tension dans la diode Zener à dépasser sa valeur de seuil.

2. Dispositif de commutation selon la revendication 1, dans lequel ledit second et/ou troisième transistor est un transistor à effet de champ dont le trajet drain-source réalise ledit trajet conducteur principal.

3. Dispositif de commutation selon la revendication 1, dans lequel ledit second et/ou troisième transistor est un transistor bipolaire dont le trajet collecteur-émetteur réalise ledit trajet conducteur principal.

4. Dispositif de commutation selon la revendication 1, dans lequel ledit second transistor est un transistor à effet de champ et ledit troisième transistor est un transistor bipolaire.

5. Dispositif de commutation selon l'une quelconque des revendications précédentes, dans lequel le point entre les trajets conducteurs principaux des premier et second transistors auquel est reliée la diode Zener est établi à un emplacement immédiatement contigu au second transistor de façon à limiter le plus possible l'inductance de dispersion entre ledit point et le trajet conducteur principal dudit second transistor.

6. Dispositif de commutation selon l'une quelconque des revendications précédentes, dans lequel une autre diode Zener (ZD4) est montée entre l'électrode de commande du troisième transistor et le côté du trajet conducteur principal du premier transistor distant du second transistor.

7. Dispositif de commutation selon la revendication 6, dans lequel ladite autre diode Zener est reliée au côté du trajet conducteur principal du premier transistor à un emplacement immédiatement contigu à ce dernier pour limiter le plus possible l'inductance de dispersion entre ledit emplacement et le premier transistor.

Fig. 1(A)

Fig. 1(B)

Fig. 2